# EUROPÄISCHE PATENTSCHRIFT

(11) **EP 3 258 741 B1**
(45) Veröffentlichungstag und Bekanntmachung des Hinweises auf die Patenterteilung: **27.03.2019**
(21) Anmeldenummer: 17170054.5
(22) Anmeldetag: 09.05.2017
(51) Int. Cl.: H05B 6/64, H05B 6/68, H05K 1/02

(54) **MIKROWELLENGENERATOR FÜR EIN MIKROWELLENGERÄT UND MIKROWELLENGERÄT**
MICROWAVE GENERATOR FOR A MICROWAVE APPARATUS AND MICROWAVE APPARATUS
GÉNÉRATEUR DE MICRO-ONDES POUR UN APPAREIL À MICRO-ONDES ET APPAREIL À MICRO-ONDES

(30) Priorität: 13.06.2016 DE 102016210388
(43) Veröffentlichungstag der Anmeldung: 20.12.2017
(73) Patentinhaber: E.G.O. Elektro-Gerätebau GmbH, 75038 Oberderdingen (DE)
(72) Erfinder: Bayer, Ewald, 72358 Dormettingen (DE); Frank, Marcus, 75038 Oberderdingen (DE); Schönemann, Konrad, 75056 Sulzfeld (DE)
(74) Vertreter: Patentanwälte Ruff, Wilhelm, Beier, Dauster & Partner mbB

(56) Entgegenhaltungen:
- EP-A2- 1 398 998
- JP-A- 2011 060 567
- JP-A- 2011 135 670
- JP-A- 2011 150 872
- JP-U- S5 993 099

## Beschreibung

### Anwendungsgebiet und Stand der Technik

Die Erfindung betrifft einen Mikrowellengenerator für ein Mikrowellengerät sowie ein mit einem solchen Mikrowellengenerator versehenes Mikrowellengerät, insbesondere einen Mikrowellenofen.

Ein Mikrowellengenerator für ein Mikrowellengerät in Form eines Mikrowellenofens ist beispielsweise aus der EP 3035773 A1 bekannt. Darin wird vor allem beschrieben, dass ein solcher Mikrowellengenerator zwei Kanäle mit jeweils einer eigenen Verstärkerschaltung und einer Antenne aufweist. Dadurch kann mit zwei unterschiedlichen Frequenzen der Mikrowellen gearbeitet werden, um beispielsweise Gargut in dem Mikrowellenofen besser bzw. schneller zu erwärmen. Das Dokument EP 1 398 998 A2 offenbart ebenfalls ein Mikrowellengenerator für ein Mikrowellengerät nach dem Stand der Technik.

### Aufgabe und Lösung

Der Erfindung liegt die Aufgabe zugrunde, einen eingangs genannten Mikrowellengenerator sowie ein damit versehenes Mikrowellengerät zu schaffen, mit denen Probleme des Standes der Technik gelöst werden können und es insbesondere möglich ist, einen Aufbau des Mikrowellengenerators praxistauglich und gleichzeitig einfach bei sicherer Funktion zu gewährleisten, wobei insbesondere der Mikrowellengenerator zwei Leistungs-Bereiche entsprechend zwei Verstärkerschaltungen aufweisen kann.
Gelöst wird diese Aufgabe durch einen Mikrowellengenerator mit den Merkmalen des Anspruchs 1 sowie einen Mikrowellenofen mit den Merkmalen des Anspruchs 12. Vorteilhafte sowie bevorzugte Ausgestaltungen der Erfindung sind Gegenstand der weiteren Ansprüche und werden im Folgenden näher erläutert. Dabei werden manche der Merkmale nur für den Mikrowellengenerator oder nur für das Mikrowellengerät beschrieben. Sie sollen jedoch unabhängig davon sowohl für den Mikrowellengenerator als auch für das Mikrowellengerät selbstständig und unabhängig voneinander oder gemeinsam gelten können. Der Wortlaut der Merkmale wird durch ausdrückliche Bezugnahme zum Inhalt der Beschreibung gemacht.
Es ist vorgesehen, dass der Mikrowellengenerator einen einzigen flachen und flächigen Bauteilträger für elektrische bzw. elektronische steuerfunktionale Bauteile als Steuer-Bauteile und für elektrische bzw. elektronische funktionale Bauteile als Leistungs-Bauteile aufweist.

Vorteilhaft gilt dies für elektrisch funktionale Bauteile, die direkt mit der Erzeugung der Mikrowellen zu tun haben. Das bedeutet, dass andere Bauteile des Mikrowellengeräts, wie beispielsweise ein Lüfter in einem Mikrowellenofen als Mikrowellengerät, eigenständige Bauteile sind bzw. eigene Bauteilträger aufweisen können mit elektrisch funktionalen Bauteilen darauf. Diese sind dann aber für die Ansteuerung der Lüfter vorgesehen und gelten somit nicht als elektrisch funktionale Bauteile für die Erzeugung der Mikrowellen. Der Bauteilträger weist ein durchgehendes Trägermaterial auf, vorteilhaft ist er einteilig bzw. einstückig ausgebildet. Dieses Trägermaterial kann dem einer üblichen Leiterplatte entsprechen und somit Fasern bzw. Glasfasern aufweisen, die in ein Matrixmaterial eingebettet sind, beispielsweise in Harz.

Auf dem Bauteilträger sind mindestens ein Leistungs-Bereich und mindestens ein Steuer-Bereich vorgesehen. Diese bilden die wesentlichen Komponenten bzw. Bauteile zur Erzeugung der Mikrowellen, vorteilhaft die einzigen elektrischen bzw. elektronischen Bauteile zur Erzeugung der Mikrowellen. In dem Steuer-Bereich können auf beiden Flachseiten des Bauteilträgers elektrisch funktionale Bauteile angeordnet sein, also oben und unten. So kann die Bauteildichte erhöht werden und der Steuer-Bereich klein gehalten werden.

In dem Leistungs-Bereich sind nur auf einer Flachseite des Bauteilträgers, insbesondere auf einer oberen Flachseite, elektrisch funktionale Bauteile angeordnet, die mindestens einen Leistungsschalter aufweisen. Auf der anderen Flachseite in dem Leistungs-Bereich sind Kühlkörper, Kühlmittel odgl. angeordnet, aber eben keine elektrisch funktionalen Bauteile. Durch diese Aufteilung im Leistungs-Bereich lässt sich eine hohe Leistungsdichte erreichen, insbesondere mit Wärmeerzeugung durch die Leistungsschalter, die vorteilhaft an sich übliche Leistungshalbleiter sind. Das Vorsehen von Kühlkörpern, Kühlmitteln odgl. auf im Wesentlichen einer eigenen, dafür sozusagen reservierten Flachseite des Bauteilträgers ermöglicht eine gute Kühlung bzw. den Abtransport einer großen Menge an erzeugter Wärme.

Somit lässt sich insgesamt mit der Erfindung ein kompakter Aufbau eines Mikrowellengenerators erreichen, der nicht besonders viel Platz benötigt bei hoher Funktionalität und insbesondere bei einem Konzept, das auch eine Erweiterung für mehrere Kanäle zur Erzeugung der Mikrowellen ermöglicht.

In Ausgestaltung der Erfindung ist vorgesehen, dass der Bauteilträger eben der einzige Bauteilträger für die vorgenannten elektrisch funktionalen Bauteile, die für die direkte Erzeugung der Mikrowellen vorgesehen sind, des gesamten des Mikrowellengenerators bzw. des gesamten Mikrowellengeräts ist. So lässt sich wiederum vor allem auch der Aufbau des Mikrowellengenerators bzw. eines gesamten Mikrowellengeräts vereinfachen.

In vorteilhafter Ausgestaltung der Erfindung ist an dem Bauteilträger ein HF-Substrat angeordnet, also sogenanntes HF-aktives Material. Vorteilhaft ist es auf einer oberen Flachseite im Leistungs-Bereich vorgesehen, und zwar dort, wo auch die vorgenannten Leistungsschalter angeordnet bzw. montiert sind. Besonders vorteilhaft kann vorgesehen sein, dass die Leistungsschalter direkt auf das HF-Substrat aufgebracht bzw. auf diesem montiert sind. Dieses HF-Substrat weist vorteilhaft gute dielektrische Eigenschaften auf. Somit stehen dessen gute dielektrische HF-Eigenschaften dort zur Verfügung, wo sie benötigt werden, nämlich im Leistungs-Bereich und insbesondere an bzw. unter den Leistungsschaltern. Es werden aber keine unnötigen Kosten verursacht für Bereiche, in denen dieses teure und evtl. aufwändig zu verarbeitende HF-Material nicht unbedingt benötigt wird.

In einer einfachen Ausgestaltung der Erfindung kann das HF-Substrat als zusätzliche Schicht oder zusätzliches flaches Bauteil auf die entsprechende Flachseite des Bauteilträgers aufgesetzt bzw. aufgeklebt werden. In einer vorteilhaften anderen Ausgestaltung ist auf dieser Flachseite des Bauteilträgers eine Ausnehmung bzw. Vertiefung vorgesehen, beispielsweise eingefräst, in welche das HF-Substrat eingebracht wird. So kann eine übermäßige Erhöhung der Dicke des Bauteilträgers durch das HF-Substrat reduziert oder vermieden werden. Besonders vorteilhaft kann das HF-Substrat oberflächenbündig im Bauteilträger bzw. in einer Ausnehmung im Bauteilträger angeordnet sein, so dass sich die Gesamtdicke des Bauteilträgers nicht erhöht. Das HF-Substrat kann eine Dicke zwischen 5% und 70% der Dicke des Bauteilträgers aufweisen, bevorzugt zwischen 25% und 50%.

Neben Leistungsschaltern können auf dem Bauteilträger im Leistungs-Bereich noch Isolatoren und Koppler vorgesehen sein. Ein Abgriff des Kopplers kann dann wiederum auf eine Messschaltung geführt sein, die im Steuer-Bereich angeordnet ist, aber nahe bei dem Koppler selbst. Die erzeugte Hochfrequenz kann dann in ein Koaxialkabel oder direkt in einen Hohlleiter oder eine Antenne eingekoppelt werden zur Einleitung in das Mikrowellengerät bzw. eine Muffel, Kavität odgl..

In möglicher Ausgestaltung der Erfindung ist im Bereich direkt unter einem Leistungsschalter eine vollständig durch den Bauteilträger gehende Ausnehmung vorgesehen, in der ein guter bis sehr guter Wärmeleiter eingesetzt ist, beispielsweise ein Metallteil, vorteilhaft ein Wärmeleiter mit Kupfer oder ähnlichem gut wärmeleitendem Material, oder auch ein Wärmerohr bzw. eine Heatpipe. Auf der Oberseite dieses Wärmeleiters sitzt dann der Leistungsschalter, möglicherweise thermisch noch besser angekoppelt durch Wärmeleitpaste odgl.. An der Unterseite des Wärmeleiters können dann ein vorgenannter Kühlkörper oder andere Kühlmittel wärmeleitend angebunden sein, um die vom Leistungsschalter erzeugte und an den Wärmeleiter abgegebene Wärme an die Luft abzuführen.

In weiterer Ausgestaltung der Erfindung kann ein erster Leistungs-Bereich auf einer Seite des Steuer-Bereichs und daneben angeordnet sein. Ein zweiter Leistungs-Bereich kann auf einer anderen bzw. der gegenüberliegenden Seite des Steuer-Bereichs und daneben angeordnet sein, so dass die beiden Leistungs-Bereiche den Steuer-Bereich zwischen sich aufweisen. So kann vorteilhaft ein Mikrowellengenerator mit zwei Kanälen aufgebaut werden, besonders vorteilhaft entsprechend der vorgenannten EP 3035773 A1.

In vorteilhafter Ausgestaltung der Erfindung kann nur ein einziger Steuer-Bereich an dem Mikrowellengenerator bzw. im Mikrowellengerät vorgesehen sein. An diesen können einige Kontakte von außen herangeführt sein als Eingang, beispielsweise für eine Kommunikation, für mindestens einen Türkontakt sowie für einen Leistungsanschluss. Insbesondere wenn im Steuer-Bereich auch ein Schaltnetzteil vorgesehen ist, ist mit Vorteil ein Leistungsanschluss vorgesehen. Eine Steuerung bzw. ein Mikro-Controller für den Mikrowellengenerator ist bevorzugt ebenfalls im Steuer-Bereich vorgesehen.

In nochmals weiterer Ausgestaltung der Erfindung kann vorgesehen sein, dass in dem Steuer-Bereich auf einer Flachseite des Bauteilträgers nur SMD-Bauteile angeordnet sind, also keine elektrisch funktionalen Bauteile, die mit Beinen odgl. in Ausnehmungen im Bauteilträger hineinragen. Auf der anderen Flachseite des Bauteilträgers sind vorteilhaft nur sogenannte THT-Bauteile vorgesehen, also solche, die eben mit Kontaktbeinen in Ausnehmungen im Bauteilträger eingesteckt sind bzw. durchgesteckt sind. Durch diese Trennung der Bauteilarten und Aufteilung auf die beiden Flachseiten des Bauteilträgers ist eine höhere Bauteildichte erreichbar, des Weiteren kann so ein Bestücken und Verlöten besser durchgeführt werden.

Es kann vorgesehen sein, dass die SMD-Bauteile auf einer oberen Flachseite des Bauteilträgers angeordnet sind, und zwar bevorzugt auf derjenigen, auf der auch die vorgenannten Leistungsschalter des Leistungs-Bereichs vorgesehen sind. Die THT-Bauteile sind dann vorteilhaft auf der anderen Flachseite des Bauteilträgers vorgesehen. Der Vorteil der Anordnung der SMD-Bauteile auf der Oberseite bzw. der oberen Flachseite liegt darin, dass dann deren geringe Bauhöhe besser genutzt wird. Vor allem wenn auf einer unteren Flachseite des Bauteilträgers die vorgenannten THT-Bauteile angeordnet sind, wo auch der vorgenannte Kühlkörper oder ein anderes Kühlmittel, welches eine größere Bauhöhe weg von der unteren Flachseite des Bauteilträgers aufweist, angeordnet sind, so können insgesamt die höheren Bauteile oder Komponenten an einer gemeinsamen Seite des Bauteilträgers vorgesehen sein. Wenn in dem Steuer-Bereich auch ein Schaltnetzteil für den Mikrowellengenerator vorgesehen ist, so werden hierfür größere Bauteile wie auch Kondensatoren benötigt, die dann vom Bedarf an Bauhöhe auch eindeutig besser zu einem Kühlkörper oder anderen Kühlmitteln passen.

Auch für die Anordnung des Schaltnetzteils an sich ist die benachbarte, vorteilhaft mit geringem Abstand vorgesehene Anordnung der Leistungs-Bereiche daneben, insbesondere auf beiden Seiten eines Steuer-Bereichs mit dem Schaltnetzteil, von Vorteil. So können die elektrischen Anschlüsse von dem Schaltnetzteil direkt nach links und nach rechts abgehen zur Versorgung der Leistungsschalter der Leistungs-Bereiche. Dabei können an dem Bauteilträger mittels an sich bekannter Durchkontaktierungen die Verbindungen von einer unteren Flachseite des Bauteilträgers zur oberen Flachseite geführt werden und dort dann an die ebenfalls auf der oberen Flachseite vorgesehenen Leistungsschalter.

Im Schaltnetzteil kann ein Netztrennrelais vorgesehen werden, um den Standby-Verbrauch des Mikrowellengenerators und eines damit vorgesehenen Mikrowellengeräts zu reduzieren.

In weiterer Ausgestaltung der Erfindung ist ein sogenannter Zirkulator vorgesehen an dem Bauteilträger, um die Verstärkerschaltung bzw. die Bauteile des Mikrowellengenerators vor rückgekoppelten Mikrowellen zu schützen. Durch den gewählten Aufbau ist es jedoch auch möglich, auf den Zirkulator zu verzichten. Dabei kann am Eingang der Ansteuerung der Leistungsbauteile durch eine Rückkopplung vom Koppler deren Ansteuerung derart zu ändern, dass die Leistungsabgabe bei zu großer rückgekoppelter Mikrowellenleistung reduziert wird. Hierfür haben sich die genannten Zirkulatoren bewährt. Dafür ist es aber sehr wichtig, dass kurze Wege in der Ansteuerung bzw. zwischen den Kopplern und den Leistungsschaltern, auch verschiedener Kanäle, vorgesehen sind. Dies ist eben mit der vorliegenden Erfindung besonders gut und einfach zu realisieren aufgrund der engen Anordnung der relevanten Bauteile beieinander. Längere HF-Kabel odgl. könnten in ein Mikrowellengerät nur schwer oder nicht integriert werden, deren Funktion wäre dann nicht mehr ausreichend gut. So kann insbesondere bei zu hoher rücklaufender Mikrowellenleistung auf einem Kanal die Leistungsabgabe bei beiden Kanälen durch eine direkt einwirkende und dadurch sehr schnell reagierende Hardwarelösung begrenzt werden.

In weiterer Ausgestaltung der Erfindung wirkt mindestens ein Signal mindestens eines Kopplers auf mindestens einen Oszillator und/oder mindestens eine Verstärkung der Leistungsschalter und/oder mindestens eine Spannungsversorgung der Leistungsschalter zurück bzw. ist rückgekoppelt. So kann bei zu hoher, reflektierter Welle die Mikrowelleneinstrahlung in die Muffel vermindert oder abgeschaltet werden.

Pro Kanal des Mikrowellengenerators kann ein Oszillator vorgesehen sein, insbesondere also zwei Oszillatoren bei zwei Kanälen. Diese Oszillatoren können synchronisiert sein, um bei kohärenter Frequenz eine Variation der Phasenlage zu erzeugen für eine bessere Erzeugung der Mikrowellen.

Nahe einer Außenseite des Bauteilträgers, insbesondere einer hinteren Außenseite und auch in Nähe zu den Leistungsschaltern bzw. Kühlkörpern oder Kühlmitteln, können in einem Mikrowellengerät ein oder mehrere Lüfter vorgesehen sein. Diese sorgen für eine ausreichende Kühlung.

In einer Ausbildung der Erfindung kann vorgesehen sein, dass der Mikrowellengenerator bzw. ein damit versehenes Mikrowellengerät insgesamt eine Leistungs-Messung und einen Kommunikationsanschluss aufweist. Diese oder Anschlüsse für diese Funktionseinheiten sind besonders vorteilhaft auf dem einzigen Bauteilträger angeordnet, insbesondere auch daran elektrisch angeschlossen.

Auf dem Bauteilträger sind auch Steuerfunktionen vorhanden, um sogenannte Türkontakte des Mikrowellengeräts zu überwachen. Hier ist eine Art Schnell- oder Notabschaltung vorgesehen, so dass beim Öffnen der Tür des Mikrowellengeräts die Erzeugung der Mikrowellen sofort gestoppt wird. Wird ein solcher Türkontakt direkt an den Bauteilträger bzw. an eine darauf vorgesehene Steuerung angeschlossen, so ist eine weitere Vereinfachung des Aufbaus eines Mikrowellengeräts möglich.

In vorteilhafter Ausgestaltung der Erfindung sind alle Schnittstellen des Mikrowellengenerators bzw. von dessen Bauteilträger in eine Richtung vorgesehen, vorteilhaft in Richtung zu einer Vorderseite des Mikrowellengeräts. Dann ist eine Kontaktierung einfacher, weil sie nur von einer Richtung aus vorgenommen werden muss, der Mikrowellengenerator selbst lässt sich dann flexibel im Mikrowellengerät platzieren. Insbesondere ein Anschluss an mindestens einen Türkontakt wird von vorne an den Mikrowellengenerator herangeführt. Dann ist auch eine Anordnung der genannten Lüfter an der Rückseite des Bauteilträgers von Vorteil, um die Kühlluft von hinten nach vorne im Mikrowellengerät zu blasen, so dass sie an der üblicherweise zugänglichen Vorderseite austreten kann. Die genannten Oszillatoren sind vorteilhaft auch in einem hinteren Bereich des Bauteilträgers angeordnet, also nahe zu vorhandenen Lüftern und entfernt von den Kontakten von außen an dem Bauteilträger.

Diese und weitere Merkmale gehen außer aus den Ansprüchen auch aus der Beschreibung und den Zeichnungen hervor, wobei die einzelnen Merkmale jeweils für sich alleine oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte und Zwischen-Überschriften beschränkt die unter diesen gemachten Aussagen nicht in ihrer Allgemeingültigkeit.

### Kurzbeschreibung der Zeichnungen

Ausführungsbeispiele der Erfindung sind in den Zeichnungen schematisch dargestellt und werden im Folgenden näher erläutert. In den Zeichnungen zeigen:
- Fig. 1: eine schematische Draufsicht auf einen erfindungsgemäßen Mikrowellengenerator für ein erfindungsgemäßes Mikrowellengerät,
- Fig. 2: einen Schnitt durch den Mikrowellengenerator bzw. dessen Bauteilträger aus Fig. 1 und
- Fig. 3: eine stark schematisierte Seitenansicht eines erfindungsgemäßen Mikrowellengeräts in Form eines Mikrowellenofens.

### Detaillierte Beschreibung der Ausführungsbeispiele

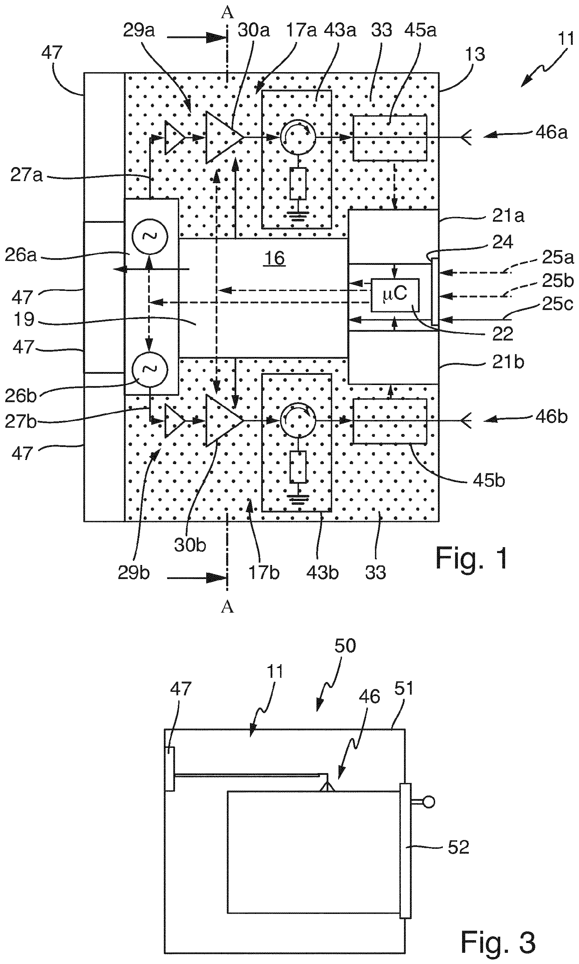

In der Fig. 1 ist in Draufsicht ein erfindungsgemäßer Mikrowellengenerator 11 schematisch dargestellt. Dieser Mikrowellengenerator 11 ist wie zuvor beschrieben für sozusagen zwei Kanäle ausgelegt, wie es aus der vorgenannten EP 3035773 A1 bekannt ist. Der Mikrowellengenerator 11 weist einen einzigen durchgehenden Bauteilträger 13 auf, vorteilhaft bestehend aus einem an sich üblichen Leiterplattenmaterial wie FR4. Dieses ist dann noch erfindungsgemäß bearbeitet, wie nachfolgend erläutert wird.

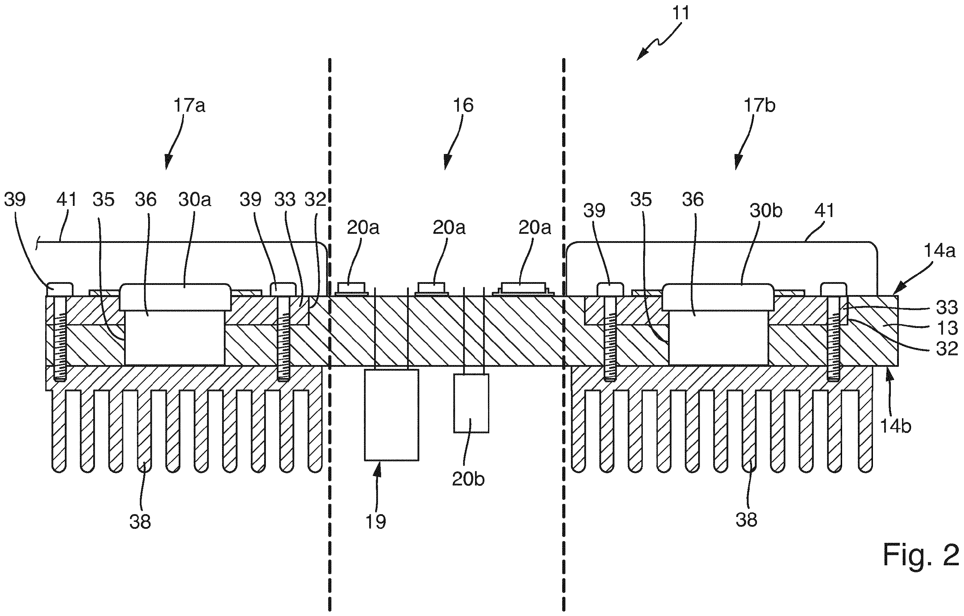

Der Bauteilträger 13 weist eine obere Flachseite 14a und eine untere Flachseite 14b auf, wie vor allem aus der Schnittdarstellung gemäß der strichpunktierten Linie A-A der Fig. 2 zu ersehen ist. Der Bauteilträger 13 ist in einen mittleren Steuerbereich 16 unterteilt und links und rechts daneben zwei Leistungs-Bereiche 17a und 17b. Hier sind der Leistungs-Bereich 17a oberhalb des Steuer-Bereichs 16 und der Leistungs-Bereich 17b darunter vorgesehen.

Im Steuer-Bereich 16 ist ein Schaltnetzteil 19 vorgesehen, vorteilhaft auf der Unterseite bzw. auf der unteren Flachseite 14b des Bauteilträgers 13, wie aus der Fig. 2 zu ersehen ist. Im Steuer-Bereich sind rechts vom Schaltnetzteil 16 Messschaltungen 21a und 21b vorgesehen, für jeden Kanal eine. Dazwischen ist ein Mikro-Controller 22 angeordnet für den gesamten Mikrowellengenerator 11, evtl. sogar für das gesamte Mikrowellengerät mit diesem Mikrowellengenerator. Es sind Anschlüsse 24 für Eingänge vorgesehen, wobei ein oberer Eingang 25a zur Kommunikation dient, insbesondere ankommend von Bedienelementen odgl. am Mikrowellengerät. Ein mittlerer Eingang 25b ist für die eingangs genannten Türkontakte vorgesehen, und ein unterer Eingang 25c ist ein Leistungsanschluss. Dieser wird möglichst direkt mittels der Anschlüsse 24 an das Schaltnetzteil 19 durchgeschleift.

Links davon und möglichst direkt an dem Schaltnetzteil 19 sind Oszillatoren 26a und 26b vorgesehen, wiederum für jeden Kanal einer. Diese überbrücken zwar sozusagen den zentralen bzw. mittleren Steuer-Bereich 16, zählen aber eigentlich zumindest teilweise schon zu Hochfrequenz-Bauteilen und somit zu den Leistungs-Bereichen 17a und 17b. Die Oszillatoren 26a und 26b sind je an einen Verstärker 29a und 29b angeschlossen. Diese Verstärker 29a und 29b weisen jeweils einen Leistungsschalter 30a und 30b auf, der signalmäßig vom Mikro-Controller 22 zusätzlich angesteuert werden kann und leistungsmäßig vom Schaltnetzteil 19 versorgt wird.

Die Verstärker 29a und 29b bzw. deren Leistungsschalter 30a und 30b sind mit Isolatoren 43a und 43b verbunden, wie sie aus dem Stand der Technik bekannt sind, welche jedoch bei dementsprechenden Abschalteinrichtungen wiederum entfallen können. Die Isolatoren sind mit Kopplern 45a und 45b verbunden, an deren jeweiligen HF-Ausgängen Antennen 46a und 46b angeschlossen sind. Dies ist wiederum aus dem Stand der Technik bekannt. Anstelle der Antennen 46, die vorteilhaft als Hohlleiter ausgebildet sind, könnte auch ein Koaxialkabel angeschlossen sein. Dies wäre dann aber insgesamt nur bei größeren Entfernungen notwendig, gleichzeitig aber aufwendig und funktional nachteilig wegen der längeren Wege und mehreren Anschlüsse.

Links am Bauteilträger 13 bzw. an einer rückwärtigen Kante sind drei Lüfter 47 vorgesehen, vorteilhaft am Bauteilträger 13 befestigt bzw. mit diesem zu einer Baueinheit verbunden, beispielsweise durch übliche Befestigungswinkel odgl.. Diese kühlen den Mikrowellengenerator 11, insbesondere dessen Verstärker 29 bzw. Leistungsschalter 30 und das Schaltnetzteil 19. So entsteht eine gut vormontierbare und gut einbaubare Baueinheit.

Wie aus der Fig. 1 durch eine Punktierung bestimmter Bereiche der oberen Flachseite 14a des Bauteilträgers 13 zu erkennen ist, kann hier eingangs genanntes HF-Substrat vorgesehen sein. Zur genaueren Erläuterung wird auf die nachfolgend beschriebene Fig. 2 verwiesen.

In der Fig. 2 ist der mittlere Steuer-Bereich 16 zu ersehen, der links neben sich den Leistungs-Bereich 17a und rechts den Leistungs-Bereich 17b aufweist. Im Steuer-Bereich 16 sind auf einer oberen Flachseite 14a des Bauteilträgers 13 die Steuer-Bauteile 20a vorgesehen in Form von SMD-Bauteilen. Vorteilhaft sind hier nur SMD-Bauteile vorgesehen, so dass eine Bauhöhe relativ gering gehalten werden kann. An einer unteren Flachseite 14b des Bauteilträgers 13 sind weitere Steuer-Bauteile 20b vorgesehen, die als sogenannte THT-Bauteile ausgebildet sind mit schematisch dargestellten Anschlussbeinen, die durch nicht näher dargestellte oder erläuterte Durchgangslöcher im Bauteilträger 13 reichen und auf einer der Flachseiten 14a oder 14b angelötet sind. Stellvertretend für das Schaltnetzteil 19 ist hier ein größeres THT-Bauteil dargestellt. Sämtliche THT-Bauteile des Steuer-Bereichs 16 sind auf der unteren Flachseite 14b angeordnet, so dass deren naturgemäß größere Bauhöhe nur dort vorgesehen ist.

Die vorgenannten weiteren Bestandteile des Steuer-Bereichs 16 wie Messschaltungen 21a und 21b sowie Mikro-Controller 22 samt Anschlüssen 24 können auch auf der oberen Flachseite 14a des Bauteilträgers 13 angeordnet sein. Dies ist hier nicht näher dargestellt. Dies hängt im Wesentlichen von ihrer Bauform ab, also ob es SMD-Bauteil oder THT-Bauteile sind. Gegebenenfalls können die Anschlüsse 24 an der unteren Flachseite 14b vorgesehen sein und mittels bekannter Durchkontaktierungen an die obere Flachseite 14a verbunden sein. Diese Anordnung hätte den Vorteil, dass dann eine direkte Durchkontaktierung des Leistungseingangs 25c an das Schaltnetzteil 19 auf der unteren Flachseite 14b möglich ist. Die Anschlüsse 24 weisen im eingebauten Zustand vorteilhaft zu einer Front oder Vorderseite des Mikrowellengeräts hin, so dass sie bzw. der gesamte Mikrowellengenerator 11 wie eingangs erläutert leicht kontaktiert werden können.

In den Leistungs-Bereichen 17a und 17b sind quasi symmetrisch die beiden Kanäle des Mikrowellengenerators 11 aufgebaut. Hier ist als Besonderheit die Anordnung von HF-Material bzw. HF-Substrat 33 in Ausnehmungen 32 in der oberen Flachseite des Bauteilträgers 13 zu erkennen. Es könnte jedoch ebenso ohne Ausnehmung auf die obere Flachseite aufgetragen sein, also vollflächig. Die Dicke des HF-Substrats 33 bzw. die Tiefe der Ausnehmungen 32 kann hier etwa 40% der Gesamtdicke des Bauteilträgers 13 betragen, dies kann aber auch mehr oder weniger sein. Das Einbringen des HF-Substrats 33 in die Ausnehmungen 32 kann auf an sich bekannte Art und Weise erfolgen, beispielsweise durch Einlegen, Einlaminieren, Eingießen oder Einkleben von entsprechendem Flachmaterial in vorher hergestellte Ausnehmungen im Bauteilträger 13. Das Vorsehen des HF-Substrats 33 mit sehr guten dielektrischen Eigenschaften in diesem Bereich dient dazu, dass dort, wo die Hochfrequenzbauteile, insbesondere im Leistungs-Bereich, eingesetzt werden, die Abstrahlungen reduziert werden.

Das hochwertige HF-Substrat 33 wird nicht im Bereich des Mikro-Controllers 22 und des Schaltnetzteils 19 bzw. im gesamten Steuer-Bereich 16 nicht benötigt. Das HF-Substrat 33 kann beispielsweise von der Fa. Rogers bezogen werden. Durch dessen Einbau wird eine Art Hybrid-Bauteilträger oder Hybrid-Leiterplatte bereitgestellt.

Auf dem HF-Substrat 33 sind die Leistungsschalter 30a und 30b aufgelegt bzw. befinden sich darüber. Da die Wärmeleiteigenschaften des HF-Substrats 33 nicht besonders gut sind, ist unterhalb der Leistungsschalter 30 jeweils ein Loch 35 durch den Bauteilträger 13 vorgesehen, in dem Wärmeleiter 36a und 36b, sogenannte Thermocoins, angeordnet sind. Diese bestehen vorteilhaft aus Kupfer und leiten die Wärme von den Leistungsschaltern 30 nach unten an jeweilige Kühlkörper 38 ab. Diese Kühlkörper 38 sind mittels Schrauben 39 unten am Bauteilträger 13 auf bekannte Art und Weise festgeschraubt. Oberhalb der Leistungsschalter 30 ist jeweils eine HF-Abschirmung 41 vorgesehen. Diese sorgt für eine geringere Aussendung von Störsignalen. Eine solche HF-Abschirmung 41 kann als eine Art Deckel aus Blech, Druckguss oder ähnlichem Material ausgebildet sein. Ein Blechdeckel erscheint dabei besonders vorteilhaft, da er Montagelaschen aufweisen kann, die durch Löcher in den Bauteilträger 13 gesteckt werden können und anschließend klemmen oder verschränkt werden zur Befestigung.

Aus den Darstellungen sind die erfindungsgemäß vorteilhaft erreichte kompakte Baugröße zu ersehen sowie die kurzen Anschlusswege. So ist beispielsweise die Distanz zwischen Schaltnetzteil 19 und Oszillatoren 26 und den Verstärkern 17 samt Leistungsschaltern 30 sehr kurz. So können auch hohe Ströme gut geleitet werden, wofür ein einziges Schaltnetzteil ausreicht.

Die Messschaltungen 21 dienen zur Messung der Leistung über die Koppler 45. Somit kann über den Mikro-Controller 22 zurück an die Oszillatoren 26 und die Verstärker 17 eine Regelschleife aufgebaut werden, um die Leistung konstant zu halten und beispielsweise Temperaturdrift zu kompensieren. Zusätzlich kann eine schnelle, hardwareseitige Abschaltung der Verstärker bei Überschreitung der Rückwärtsleistung am Koppler umgesetzt werden. Durch dieses Mittel können die Zirkulatoren eingespart werden und die Leistungsschalter 30 sind dennoch geschützt.

In allgemeiner Ausgestaltung der Erfindung kann vorgesehen sein, dass das Schaltnetzteil so ausgebildet ist, dass seine Ausgangsspannung veränderbar ist. So kann eine Leistungsanpassung des Mikrowellengenerators 11 erfolgen, beispielsweise bei schlechtem Leistungseintrag in ein Gargut bei einem erfindungsgemäßen Mikrowellenofen als Mikrowellengerät. Des Weiteren ist durch die kompakte Bauweise des Mikrowellengenerators 11 eine schnelle Reaktion bzw. Beeinflussung von einem Kanal auf den anderen möglich. Auch die Integration des Schaltnetzteils 19 in den Mikrowellengenerator 11 bzw. auf dessen einzigen Bauteilträger 13 verringert die Baugröße und spart Material- sowie Montagekosten, beispielsweise durch lokale Kondensatoren zur Zwischenspeicherung von Ladung. Zusätzlich können Störeinflüsse verringert werden.

Ein Abgleich der HF-Schaltung in einem Leistungs-Bereich kann auf dem Bauteilträger 13 direkt erfolgen. Dazu können integrierte Mittel zum Abgleich vorgesehen sein, wie dies dem Fachmann an sich aber bekannt ist.

In der Fig. 3 ist ein erfindungsgemäßes Mikrowellengerät als Mikrowellenofen 50 dargestellt. Der Mikrowellenofen 50 weist ein Gehäuse 51 mit einer Tür 52 auf, welche in eine Muffel 54 als Kavität führt. Oberhalb davon ist der erfindungsgemäße Mikrowellengenerator 11 im Gehäuse 51 angeordnet. An eine Rückseite des Gehäuses 51 führen die Lüfter 47 bzw. werden von dort mit Frischluft versorgt. Der Mikrowellengenerator 11 erstreckt sich zumindest teilweise über die Muffel 54. Die vorbeschriebenen Antennen 46 sind nach unten hin bzw. auf die Muffel 54 gerichtet.

An der Tür 52 sind an sich bekannte, hier nicht näher dargestellte Türkontakte vorgesehen, beispielsweise dort wo die Tür 52 in eine Art Schloss oder Verriegelung am Gehäuse 51 eingreift. Diese Türkontakte werden am Eingang 25b an die Anschlüsse 24 entsprechend Fig. 1 geführt.

## Patentansprüche

1. Mikrowellengenerator (11) für ein Mikrowellengerät (50) mit:
- einem einzigen Bauteilträger (13) für Steuer-Bauteile (19, 20, 21, 22) und Leistungs-Bauteile (29, 30, 43, 45),
- der Bauteilträger weist ein durchgehendes Trägermaterial auf,
- auf dem Bauteilträger sind mindestens ein Leistungs-Bereich (17) und mindestens ein Steuer-Bereich (16) vorgesehen, **dadurch gekennzeichnet, dass**
- in dem Steuer-Bereich (16) auf beiden Flachseiten (14a, 14b) des Bauteilträgers (13) elektrisch funktionale Bauteile (19-22) angeordnet sind,
- in dem Leistungs-Bereich (17) nur auf einer Flachseite (14a) elektrisch funktionale Bauteile (29, 30, 43, 45) mit mindestens einem Leistungsschalter (30) angeordnet sind, und dass
- in dem Leistungs-Bereich (17) auf einer anderen Flachseite (14b) Kühlkörper (38), Kühlmittel odgl. angeordnet sind.

2. Mikrowellengenerator nach Anspruch 1, **dadurch gekennzeichnet, dass** der Bauteilträger (13) der einzige Bauteilträger für elektrisch funktionale Bauteile (19-22, 29, 30, 43, 45) zur Mikrowellenerzeugung des gesamten Mikrowellengeräts (50) ist.

3. Mikrowellengenerator nach Anspruch 1 oder 2, **dadurch gekennzeichnet, dass** an dem Bauteilträger (13) ein HF-Substrat (33) angeordnet ist, vorzugsweise auf einer oberen Flachseite (14a) im Leistungs-Bereich (17), an der auch die Leistungsschalter (30) montiert sind.

4. Mikrowellengenerator nach Anspruch 3, **dadurch gekennzeichnet, dass** die Leistungsschalter (30) auf dem HF-Substrat montiert sind.

5. Mikrowellengenerator nach Anspruch 3 oder 4, **dadurch gekennzeichnet, dass** das HF-Substrat (33) in die obere Flachseite (14a) des Bauteilträgers (13) in Ausnehmungen (32) versenkt eingebracht ist, insbesondere oberflächenbündig.

6. Mikrowellengenerator nach einem der vorhergehenden Ansprüche, **dadurch gekennzeichnet, dass** im Bereich direkt unter einem Leistungsschalter (30) eine vollständig durch den Bauteilträger gehende Ausnehmung (35) vorgesehen ist, in der ein guter Wärmeleiter (36) eingesetzt ist, wobei auf der Oberseite dieses Wärmeleiters der Leistungsschalter (30) angeordnet ist und an der Unterseite des Wärmeleiters (36) ein Kühlkörper (38) oder andere Kühlmittel wärmeleitend angebunden sind.

7. Mikrowellengenerator nach einem der vorhergehenden Ansprüche, **dadurch gekennzeichnet, dass** ein erster Leistungs-Bereich (17a) auf einer Seite des Steuer-Bereichs (16) und daneben ein zweiter Leistungs-Bereich (17b) auf einer anderen Seite des Steuer-Bereichs daneben angeordnet sind.

8. Mikrowellengenerator nach einem der vorhergehenden Ansprüche, **dadurch gekennzeichnet, dass** in dem Steuer-Bereich (16) auf einer Flachseite (14a) des Bauteilträgers (13) nur SMD-Bauteile (20a) angeordnet sind und auf der anderen Flachseite (14b) nur THT-Bauteile (19, 20b), wobei vorzugsweise die SMD-Bauteile auf einer oberen Flachseite (14a) des Bauteilträgers angeordnet sind, auf der auch Leistungsschalter (30) des Leistungs-Bereichs (17) angeordnet sind.

9. Mikrowellengenerator nach einem der vorhergehenden Ansprüche, **dadurch gekennzeichnet, dass** auf dem einzigen Bauteilträger (13) eine Leistungs-Messung (21), ein Kommunikationsanschluss (24) und mindestens ein Anschluss für mindestens einen Türkontakt (25b) angeordnet sind bzw. angeschlossen sind.

10. Mikrowellengenerator nach einem der vorhergehenden Ansprüche, **dadurch gekennzeichnet, dass** ein Zirkulator (21, 45) vorgesehen ist an dem Bauteilträger (13) zur Erkennung von rückgekoppelten Mikrowellen, wobei der Zirkulator dazu ausgebildet ist, am Eingang der Ansteuerung der Leistungs-Bauteile (30) durch Rückkopplung deren Ansteuerung derart zu ändern, dass sie durch rückgekoppelte Mikrowellen nicht beschädigt werden.

11. Mikrowellengenerator nach einem der vorhergehenden Ansprüche, **dadurch gekennzeichnet, dass** mindestens ein Signal mindestens eines Kopplers auf mindestens einen Oszillator (26) und/oder mindestens eine Verstärkung der Leistungsschalter (30) und/oder mindestens eine Spannungsversorgung der Leistungsschalter rückwirkt, um bei zu hoher, reflektierter Welle die Mikrowelleneinstrahlung in die Muffel (54) zu vermindern oder abzuschalten.

12. Mikrowellengerät (50) mit einem Mikrowellengenerator (11) nach einem der vorhergehenden Ansprüche.

13. Mikrowellengerät nach Anspruch 12, **dadurch gekennzeichnet, dass** das Mikrowellengerät ein Mikrowellenofen (50) ist.

14. Mikrowellengerät nach Anspruch 12 oder 13, **dadurch gekennzeichnet, dass** alle Schnittstellen (24) des Mikrowellengenerators (11) bzw. von dessen Bauteilträger (13) in eine Richtung vorgesehen sind, vorzugsweise in Richtung zu einer Vorderseite des Mikrowellengeräts (50)

15. Mikrowellengerät nach Anspruch 14, **dadurch gekennzeichnet, dass** ein Anschluss (25b) an einen Türkontakt von vorne an den Mikrowellengenerator herangeführt ist, wobei vorzugsweise mindestens ein Lüfter (47) an der Rückseite des Bauteilträgers angeordnet ist.

## Claims

1. Microwave generator (11) for a microwave device (50), having:
- a single component carrier (13) for control components (19, 20, 21, 22) and power components (29, 30, 43, 45),
- said component carrier comprises a continuous carrier material,
- at least one power region (17) and at least one control region (16) are provided on said component carrier,
**characterized in that**
- in the control region (16), on both flat sides (14a, 14b) of said component carrier (13) electrically functional components (19-22) are arranged,
- in the power region (17) only on one flat side (14a) electrically functional components (29, 30, 43, 45) with at least one power switch (30) are arranged, and **in that**
- in the power region (17) on another flat side (14b) heat sinks (38), cooling means or the like are arranged.

2. Microwave generator according to Claim 1, **characterized in that** said component carrier (13) is the only component carrier for electrically functional components (19-22, 29, 30, 43, 45) for microwave generation of the entire microwave device (50).

3. Microwave generator according to Claim 1 or 2, **characterized in that** an RF substrate (33) is arranged on said component carrier (13), preferably on an upper flat side (14a) in said power region (17), wherein on said upper flat side said power switches (30) are also mounted.

4. Microwave generator according to Claim 3, **characterized in that** said power switches (30) are mounted on said RF substrate.

5. Microwave generator according to Claim 3 or 4, **characterized in that** said RF substrate (33) is fitted sunk in recesses into said upper flat side (14a) of said component carrier (13), in particular fitted flush with a surface of said component carrier.

6. Microwave generator according to any of the preceding Claims, **characterized in that**, in a region directly below a power switch (30), a recess (35) extending fully through said component carrier is provided, wherein a good heat conductor (36) is fitted into said recess, wherein the power switch (30) is arranged on an upper side of said heat conductor and a heat sink (38) or other cooling means are thermally conductively connected to a lower side of the heat conductor (36).

7. Microwave generator according to any of the preceding Claims, **characterized in that** a first power region (17a) is arranged on one side of said control region (16), and beside said first power region a second power region (17b) is arranged on another side of said control region.

8. Microwave generator according to any of the preceding Claims, **characterized in that** in said control region (16), only SMD components (20a) are arranged on a flat side (14a) of said component carrier (13), and only THT components (19, 20b) are arranged on the other flat side (14b) of said component carrier (13), wherein preferably the SMD components are arranged on an upper flat side (14a) of said component carrier, on which also power switches (30) of said power region (17) are arranged.

9. Microwave generator according to any of the preceding Claims, **characterized in that** a power measurement (21), a communication connection (24) and at least one connection for at least one door contact (25b) are arranged and connected, respectively, on said single component carrier (13).

10. Microwave generator according to any of the preceding Claims, **characterized in that** a circulator (21, 45) is provided on said component carrier (13) in order to detect fed-back microwaves, wherein the circulator is configured, at an input of the control of said power components (30), to modify controlling of said power components by feedback in such a way that said power components are not damaged by fed-back microwaves.

11. Microwave generator according to any of the preceding Claims, **characterized in that** at least one signal of at least one coupler acts back on at least one oscillator (26) and/or at least one gain of said power switches (30) and/or at least one voltage supply of said power switches, in order to reduce or switch off a microwave incidence into the compartment (54) in an event of an excessively high reflected wave.

12. Microwave device (50) having a microwave generator (11) according to any of the preceding Claims.

13. Microwave device according to Claim 12, **characterized in that** the microwave device is a microwave oven (50).

14. Microwave device according to Claim 12 or 13, **characterized in that** all interfaces (24) of said microwave generator (11), or of the component carrier (13) of said microwave generator, are provided in one direction, preferably in a direction towards a front side of said microwave device (50).

15. Microwave device according to Claim 14, **characterized in that** a connection (25b) to a door contact is led to said microwave generator from the front, wherein preferably at least one fan (47) is arranged on a rear side of said component carrier.

## Revendications

1. Générateur de micro-ondes (11) pour un appareil à micro-ondes (50), comprenant:
- un seul support de composant (13) pour composants de commande (19, 20, 21, 22) et composants de puissance (29, 30, 43, 45),
- le support de composant présentant un matériau de support en continu,
- sur le support de composant étant prévues au moins une région de puissance (17) et au moins une région de commande (16),
**caractérisé en ce que**
- dans la région de commande (16) sur deux côtés plats (14a, 14b) du support de composant (13) sont arrangés des composants électriquement fonctionnels (19-22),
- dans la région de puissance (17) seulement sur un côté plat (14a) sont arrangés des composants électriquement fonctionnels (29, 30, 43, 45) avec au moins un interrupteur de puissance (30), et **en ce que**
- dans la région de puissance (17) sur un autre côté plat (14b) sont arrangés des dissipateurs thermiques (38), des moyens réfrigérants ou autres.

2. Générateur de micro-ondes selon la revendication 1, **caractérisé en ce que** le support de composant (13) est le seul support de composant pour composants électriquement fonctionnels (19-22, 29, 30, 43, 45) pour la génération de micro-ondes de l'entier appareil à micro-ondes (50).

3. Générateur de micro-ondes selon la revendication 1 ou 2, **caractérisé en ce qu'**un substrat RF (33) est arrangé sur le support de composant (13), de préférence sur un côté plat (14a) supérieur dans la région de puissance (17) où aussi les interrupteurs de puissance (30) sont montés.

4. Générateur de micro-ondes selon la revendication 3, **caractérisé en ce que** les interrupteurs de puissance (30) sont montés sur le substrat RF.

5. Générateur de micro-ondes selon la revendication 3 ou 4, **caractérisé en ce que** le substrat RF (33) est introduit dans le côté plat (14a) supérieur du support de composant (13) encastré dans des évidements (32), en particulier à fleur de la surface.

6. Générateur de micro-ondes selon l'une quelconque des revendications précédentes, **caractérisé en ce que** dans la région directement au-dessous d'un interrupteur de puissance (30) est prévu un évidement (35) traversant le support de composant complètement, dans ledit évidement est inséré un fort conducteur de chaleur (36), dans lequel sur la face supérieure dudit conducteur de chaleur l'interrupteur de puissance (30) est arrangé et sur la face inférieure dudit conducteur de chaleur (36) un dissipateur thermique (38) ou d'autres moyens réfrigérants sont raccordés de manière thermo-conductrice.

7. Générateur de micro-ondes selon l'une quelconque des revendications précédentes, **caractérisé en ce qu'**une première région de puissance (17a) est arrangée sur un côté de la région de commande (16) et avoisinant est arrangée une deuxième région de puissance (17b) sur un autre côté de la région de commande adjacente.

8. Générateur de micro-ondes selon l'une quelconque des revendications précédentes, **caractérisé en ce que** dans la région de commande (16) sur un côté plat (14a) du support de composant (13) sont arrangés seulement des composants CMS (20a) et sur l'autre côté plat (14b) seulement des composants THT (19, 20b), dans lequel de préférence les composants CMS sont arrangés sur un côté plat (14a) supérieur du support de composant où aussi des interrupteurs de puissance (30) de la région de puissance (17) sont arrangés.

9. Générateur de micro-ondes selon l'une quelconque des revendications précédentes, **caractérisé en ce que** sur le seul support de composant (13) sont arrangés ou bien raccordés une mesure de puissance (21), un raccordement de communication (24) et au moins un raccordement pour au moins un contact de porte (25b).

10. Générateur de micro-ondes selon l'une quelconque des revendications précédentes, **caractérisé en ce qu'**un circulateur (21, 45) est prévu sur le support de composant (13) pour détecter des micro-ondes rétroactives, dans lequel le circulateur est configuré pour varier l'excitation des composants de puissance (30) à l'entrée de commande par rétroaction de telle manière que lesdits composants de puissance ne soient pas endommagés par des micro-ondes rétroactives.

11. Générateur de micro-ondes selon l'une quelconque des revendications précédentes, **caractérisé en ce que** au moins un signal d'au moins un coupleur est/sont rétroactif(s) sur au moins un oscillateur (26) et/ou au moins un gain des interrupteurs de puissance (30) et/ou au moins une alimentation de tension des interrupteurs de puissance afin de diminuer ou de déconnecter l'incidence de micro-ondes dans le moufle (54) en cas d'onde réfléchie excessivement.

12. Appareil à micro-ondes (50) comprenant un générateur de micro-ondes (11) selon l'une quelconque des revendications précédentes.

13. Appareil à micro-ondes selon la revendication 12, **caractérisé en ce que** l'appareil à micro-ondes est un four à micro-ondes (50).

14. Appareil à micro-ondes selon la revendication 12 ou 13, **caractérisé en ce que** toutes les interfaces (24) du générateur de micro-ondes (11) ou bien de son support de composant (13) sont prévues dans une direction, de préférence dans la direction vers une face avant de l'appareil à micro-ondes (50).

15. Appareil à micro-ondes selon la revendication 14, **caractérisé en ce qu'**un raccordement (25b) à un contact de porte est mené au générateur de micro-ondes de l'avant, dans lequel de préférence au moins un ventilateur (47) est disposé sur la face arrière du support de composant.
